# EUROPEAN PATENT APPLICATION

(11) **EP 4 670 533 A1**
(43) Date of publication of application: **31.12.2025**
(21) Application number: 23924370.2
(22) Date of filing: 27.12.2023
(51) Int. Cl.: A24F 40/46, A24F 40/51, A24F 40/57, A24F 40/465, H05B 3/00, H05B 6/10, H05B 6/36, H05B 6/06, A24D 1/02, D21H 19/04

(54) **AEROSOL-GENERATING DEVICE**

(30) Priority: 23.02.2023 KR 20230024597; 16.05.2023 KR 20230063277
(71) Applicant: KT&G Corporation, Daedeok-gu Daejeon 34337 (KR)
(72) Inventor: KIM, Dong Sung, Seoul 06310 (KR); KWON, Young Bum, Yongin-si, Gyeonggi-do 16930 (KR); KIM, Yong Hwan, Anyang-si, Gyeonggi-do 13970 (KR); LIM, Hun Il, Seoul 05555 (KR)
(74) Representative: AWA Sweden AB
(86) International application number: PCT/KR2023/021691
(87) International publication number: WO 2024/177264

(57) **Abstract**

An aerosol generating device includes a housing including an accommodation space for accommodating an aerosol generating article, a heater configured to heat the aerosol generating article accommodated in the accommodation space, and a circuit board including a first sensor for sensing a capacitance change in the accommodation space and a second sensor for sensing an inductance change in the accommodation space.

## Description

### [Technical Field]

The disclosure relates to an aerosol generating device, and more particularly, to an aerosol generating device including a structure in which a plurality of sensors are integrated.

### [Background Art]

Recently, the demand for alternative methods for overcoming the shortcomings of general cigarettes has increased. For example, there is an increasing demand for a system for generating aerosols by heating a cigarette or an aerosol generating material by using an aerosol generating device, rather than by burning cigarettes. Accordingly, research on heating-type aerosol generating devices has been actively conducted.

Because of the limited size of an aerosol generating device, studies on the efficient arrangement of components in the limited inner space are being actively conducted.

### [Disclosure]

### [Technical Problem]

Additional functions that may provide a user with user convenience may be added to an aerosol generating device.

To incorporate various functions into an aerosol generating device while realizing a compact design, components related to the various functions need to be efficiently arranged in the limited inner space of the aerosol generating device.

Provided is an aerosol generating device having an improved structure in relation to components that perform additional functions associated with the heating of an aerosol generating article.

The technical problems of the present disclosure are not limited to the above-described description, and other technical problems may be clearly understood by one of ordinary skill in the art from the embodiments to be described hereinafter.

### [Technical Solution]

According to an embodiment, an aerosol generating device may include a housing including an accommodation space for accommodating an aerosol generating article, a heater for heating the aerosol generating article accommodated in the accommodation space, and a circuit board that includes a first sensor for sensing a capacitance change in the accommodation space and a second sensor for sensing an inductance change in the accommodation space.

### [Advantageous Effects]

In an aerosol generating device according to embodiments, a limited inner space of the aerosol generating device may be efficiently utilized.

Also, in an aerosol generating device according to embodiments, manufacturing processes may be simplified and manufacturing costs may be reduced in terms of the assembly of the aerosol generating device.

Effects of the present disclosure are not limited to the above effects, and effects that are not mentioned could be clearly understood by one of ordinary skill in the art from the present specification and the attached drawings.

### [Description of Drawings]

FIGS. 1 to 3 are diagrams showing examples of an aerosol generating device;
FIG. 4 is a perspective view of an aerosol generating device according to an embodiment;
FIG. 5 is a schematic cross-sectional view of an interior of the aerosol generating device of FIG. 4;
FIG. 6A is a perspective view of a heater assembly of the aerosol generating device of FIG. 5;
FIG. 6B is an exploded perspective view of the heater assembly of FIG. 6A;
FIG. 6C is a side cross-sectional view of the heater assembly of FIG. 6A in a VI-VI direction;
FIG. 7 is a perspective view of a circuit board of FIG. 6B;
FIGS. 8A and 8B respectively are perspective views of the heater assembly of FIG. 6A from which some components are omitted; and
FIG. 9 is a block diagram of an aerosol generating device according to another embodiment.

### [Mode for Invention]

Regarding the terms in the various embodiments, the general terms which are currently and widely used are selected in consideration of functions of structural elements in the various embodiments of the present disclosure. However, meanings of the terms can be changed according to intention, a judicial precedence, the appearance of a new technology, and the like. In addition, in certain cases, terms which can be arbitrarily selected by the applicant in particular cases. In such a case, the meaning of the terms will be described in detail at the corresponding portion in the description of the present disclosure. Therefore, the terms used in the various embodiments of the present disclosure should be defined based on the meanings of the terms and the descriptions provided herein.

In addition, unless explicitly described to the contrary, the word "comprise" and variations such as "comprises" or "comprising" will be understood to imply the inclusion of stated elements but not the exclusion of any other elements. In addition, the terms "-er", "-or", and "module" described in the specification mean units for processing at least one function and operation and can be implemented by hardware components or software components and combinations thereof.

As used herein, when an expression such as "at least any one" precedes arranged elements, it modifies all elements rather than each arranged element. For example, the expression "at least any one of a, b, and c" should be construed to include a, b, c, or a and b, a and c, b and c, or a, b, and c.

In an embodiment, an aerosol generating device may be a device that generates aerosols by electrically heating a cigarette accommodated in an interior space thereof.

The aerosol generating device may include a heater. In an embodiment, the heater may be an electro-resistive heater. For example, the heater may include an electrically conductive track, and the heater may be heated when currents flow through the electrically conductive track.

The heater may include a tube-shaped heating element, a plate-shaped heating element, a needle-shaped heating element, or a rod-shaped heating element, and may heat the inside or outside of a cigarette according to the shape of a heating element.

A cigarette may include a tobacco rod and a filter rod. The tobacco rod may be formed of sheets, strands, and tiny bits cut from a tobacco sheet. Also, the tobacco rod may be surrounded by a heat conductive material. For example, the heat conductive material may be, but is not limited to, a metal foil such as aluminum foil.

The filter rod may include a cellulose acetate filter. The filter rod may include at least one segment. For example, the filter rod may include a first segment configured to cool aerosols, and a second segment configured to filter a certain component in aerosols.

In another embodiment, the aerosol generating device may be a device that generates aerosols by using a cartridge containing an aerosol generating material.

The aerosol generating device may include a cartridge that contains an aerosol generating material, and a main body that supports the cartridge. The cartridge may be detachably coupled to the main body, but is not limited thereto. The cartridge may be integrally formed or assembled with the main body, and may also be fixed to the main body so as not to be detached from the main body by a user. The cartridge may be mounted on the main body while accommodating an aerosol generating material therein. However, the present disclosure is not limited thereto. An aerosol generating material may also be injected into the cartridge while the cartridge is coupled to the main body.

The cartridge may contain an aerosol generating material in any one of various states, such as a liquid state, a solid state, a gaseous state, a gel state, or the like. The aerosol generating material may include a liquid composition. For example, the liquid composition may be a liquid including a tobacco-containing material having a volatile tobacco flavor component, or a liquid including a non-tobacco material.

The cartridge may be operated by an electrical signal or a wireless signal transmitted from the main body to perform a function of generating aerosols by converting the phase of an aerosol generating material inside the cartridge into a gaseous phase. The aerosols may refer to a gas in which vaporized particles generated from an aerosol generating material are mixed with air.

In another embodiment, the aerosol generating device may generate aerosols by heating a liquid composition, and generated aerosols may be delivered to a user through a cigarette. That is, the aerosols generated from the liquid composition may move along an airflow passage of the aerosol generating device, and the airflow passage may be configured to allow aerosols to be delivered to a user by passing through a cigarette.

In another embodiment, the aerosol generating device may be a device that generates aerosols from an aerosol generating material by using an ultrasonic vibration method. At this time, the ultrasonic vibration method may mean a method of generating aerosols by converting an aerosol generating material into aerosols with ultrasonic vibration generated by a vibrator.

The aerosol generating device may include a vibrator, and generate a short-period vibration through the vibrator to convert an aerosol generating material into aerosols. The vibration generated by the vibrator may be ultrasonic vibration, and the frequency band of the ultrasonic vibration may be in a frequency band of about 100 kHz to about 3.5 MHz, but is not limited thereto.

The aerosol generating device may further include a wick that absorbs an aerosol generating material. For example, the wick may be arranged to surround at least one area of the vibrator, or may be arranged to contact at least one area of the vibrator.

As a voltage (for example, an alternating voltage) is applied to the vibrator, heat and/or ultrasonic vibrations may be generated from the vibrator, and the heat and/or ultrasonic vibrations generated from the vibrator may be transmitted to the aerosol generating material absorbed in the wick. The aerosol generating material absorbed in the wick may be converted into a gaseous phase by heat and/or ultrasonic vibrations transmitted from the vibrator, and as a result, aerosols may be generated.

For example, the viscosity of the aerosol generating material absorbed in the wick may be lowered by the heat generated by the vibrator, and as the aerosol generating material having a lowered viscosity is granulated by the ultrasonic vibrations generated from the vibrator, aerosols may be generated, but is not limited thereto.

In another embodiment, the aerosol generating device is a device that generates aerosols by heating an aerosol generating article accommodated in the aerosol generating device in an induction heating method.

The aerosol generating device may include a susceptor and a coil. In an embodiment, the coil may apply a magnetic field to the susceptor. As power is supplied to the coil from the aerosol generating device, a magnetic field may be formed inside the coil. In an embodiment, the susceptor may be a magnetic body that generates heat by an external magnetic field. As the susceptor is positioned inside the coil and a magnetic field is applied to the susceptor, the susceptor generates heat to heat an aerosol generating article. In addition, optionally, the susceptor may be positioned within the aerosol generating article.

In another embodiment, the aerosol generating device may further include a cradle.

The aerosol generating device may configure a system together with a separate cradle. For example, the cradle may charge a battery of the aerosol generating device. Alternatively, the heater may be heated when the cradle and the aerosol generating device are coupled to each other.

Hereinafter, the present disclosure will now be described more fully with reference to the accompanying drawings, in which exemplary embodiments of the present disclosure are shown such that one of ordinary skill in the art may easily work the present disclosure. The present disclosure may be implemented in a form that can be implemented in the aerosol generating devices of the various embodiments described above or may be implemented in various different forms, and is not limited to the embodiments described herein.

Hereinafter, embodiments of the present disclosure will be described in detail with reference to the drawings.

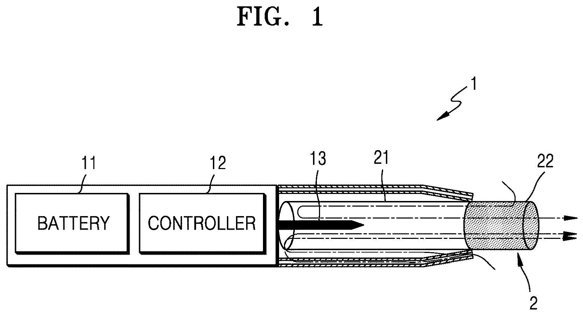

FIGS. 1 to 3 are diagrams showing examples of an aerosol generating device.

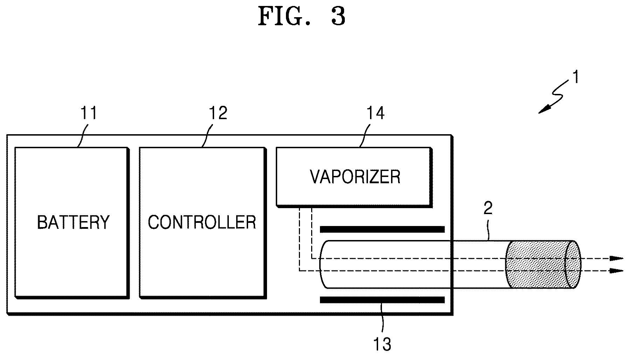

FIGS. 1 and 3 are diagrams showing examples in which a cigarette is inserted into the aerosol generating device.

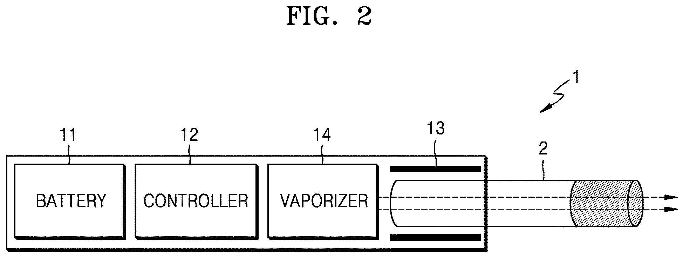

Referring to FIG. 1, the aerosol generating device 1 may include a battery 11, a controller 12, and a heater 13. Referring to FIGS. 2 and 3, the aerosol generating device 1 may further include a vaporizer 14. Also, the aerosol generating article 2 may be inserted into an inner space of the aerosol generating device 1.

FIGS. 1 to 3 show components of the aerosol generating device 1, which are related to the present embodiment. Therefore, it will be understood by one of ordinary skill in the art related to the present embodiment that other general-purpose components may be further included in the aerosol generating device 1, in addition to the components shown in FIGS. 1 to 3.

Also, FIGS. 2 and 3 show that the aerosol generating device 1 includes the heater 13. However, as necessary, the heater 13 may be omitted.

FIG. 1 shows that the battery 11, the controller 12, and the heater 13 are arranged in series. Also, FIG. 2 shows that the battery 11, the controller 12, the vaporizer 14, and the heater 13 are arranged in series. Also, FIG. 3 shows that the vaporizer 14 and the heater 13 are arranged in parallel. However, the internal structure of the aerosol generating device 1 is not limited to the structures shown in FIGS. 1 to 3. In other words, according to the design of the aerosol generating device 1, the battery 11, the controller 12, the heater 13, and the vaporizer 14 may be differently arranged.

When the aerosol generating article 2 is inserted into the aerosol generating device 1, the aerosol generating device 1 may operate the heater 13 and/or the vaporizer 14 to generate an aerosol. The aerosol generated by the heater 13 and/or the vaporizer 14 is delivered to a user by passing through the aerosol generating article 2.

In some cases, the aerosol generating device 1 may heat the heater 13 even when the aerosol generating article 2 is not inserted into the aerosol generating device 1.

The battery 11 may supply power used for the aerosol generating device 1 to operate. For example, the battery 11 may supply power to heat the heater 13 or the vaporizer 14 and supply power used for the controller 12 to operate. Also, the battery 11 may supply power required for operations of a display, a sensor, a motor, etc. mounted in the aerosol generating device 1.

The controller 12 may generally control the operation of the aerosol generating device 1. In detail, the controller 12 may control not only operations of the battery 11, the heater 13, and the vaporizer 14, but also operations of other components included in the aerosol generating device 1. Also, the controller 12 may check a state of each of the components of the aerosol generating device 1 to determine whether or not the aerosol generating device 1 is able to operate.

The controller 12 may include at least one processor. A processor can be implemented as an array of a plurality of logic gates or can be implemented as a combination of a general-purpose microprocessor and a memory in which a program executable in the microprocessor is stored. It will be understood by one of ordinary skill in the art that the processor can be implemented in other forms of hardware.

The heater 13 may be heated by the power supplied from the battery 11. For example, when the cigarette is inserted into the aerosol generating device 1, the heater 13 may be located outside the cigarette. Thus, the heated heater 13 may increase a temperature of an aerosol generating material in the cigarette.

The heater 13 may include an electro-resistive heater. For example, the heater 13 may include an electrically conductive track, and the heater 13 may be heated when currents flow through the electrically conductive track. However, the heater 13 is not limited to the example described above and may include all heaters which may be heated to a desired temperature. Here, the desired temperature may be pre-set in the aerosol generating device 1 or may be set by a user.

As another example, the heater 13 may include an induction heater. In detail, the heater 13 may include an electrically conductive coil for heating a cigarette in an induction heating method, and the cigarette may include a susceptor which may be heated by the induction heater.

For example, the heater 13 may include a tube-type heating element, a plate-type heating element, a needle-type heating element, or a rod-type heating element, and may heat the inside or the outside of the aerosol generating article 2, according to the shape of the heating element.

Also, the aerosol generating device 1 may include a plurality of heaters 13. Here, the plurality of heaters 13 may be inserted into the aerosol generating article 2 or may be arranged outside the aerosol generating article 2. Also, some of the plurality of heaters 13 may be inserted into the aerosol generating article 2 and the others may be arranged outside the aerosol generating article 2. In addition, the shape of the heater 13 is not limited to the shapes illustrated in FIGS. 1 to 3 and may include various shapes.

The vaporizer 14 may generate an aerosol by heating a liquid composition, and the generated aerosol may pass through the aerosol generating article 2 to be delivered to a user. In other words, the aerosol generated via the vaporizer 14 may move along an airflow passage of the aerosol generating device 1 and the airflow passage may be configured such that the aerosol generated via the vaporizer 14 passes through the cigarette to be delivered to the user.

For example, the vaporizer 14 may include a liquid storage, a liquid delivery element, and a heating element, but it is not limited thereto. For example, the liquid storage, the liquid delivery element, and the heating element may be included in the aerosol generating device 1 as independent modules.

The liquid storage may store a liquid composition. For example, the liquid composition may be a liquid including a tobacco-containing material having a volatile tobacco flavor component, or a liquid including a non-tobacco material. The liquid storage may be formed to be detachable from the vaporizer 14 or may be formed integrally with the vaporizer 14.

For example, the liquid composition may include water, a solvent, ethanol, plant extract, spices, flavorings, or a vitamin mixture. The spices may include menthol, peppermint, spearmint oil, and various fruit-flavored ingredients, but are not limited thereto. The flavorings may include ingredients capable of providing various flavors or tastes to a user. Vitamin mixtures may be a mixture of at least one of vitamin A, vitamin B, vitamin C, and vitamin E, but are not limited thereto. Also, the liquid composition may include an aerosol forming substance, such as glycerin and propylene glycol.

The liquid delivery element may deliver the liquid composition of the liquid storage to the heating element. For example, the liquid delivery element may be a wick such as cotton fiber, ceramic fiber, glass fiber, or porous ceramic, but is not limited thereto.

The heating element is an element for heating the liquid composition delivered by the liquid delivery element. For example, the heating element may be a metal heating wire, a metal hot plate, a ceramic heater, or the like, but is not limited thereto. In addition, the heating element may include a conductive filament such as nichrome wire and may be positioned as being wound around the liquid delivery element. The heating element may be heated by a current supply and may transfer heat to the liquid composition in contact with the heating element, thereby heating the liquid composition. As a result, an aerosol may be generated.

For example, the vaporizer 14 may be referred to as a cartomizer or an atomizer, but it is not limited thereto.

The aerosol generating device 1 may further include general-purpose components in addition to the battery 11, the controller 12, the heater 13, and the vaporizer 14. For example, the aerosol generating device 1 may include a display capable of outputting visual information and/or a motor for outputting tactile information. Also, the aerosol generating device 1 may include at least one sensor (a puff detecting sensor, a temperature detecting sensor, a cigarette insertion detecting sensor, etc.). Also, the aerosol generating device 1 may be formed as a structure that, even when the aerosol generating article 2 is inserted into the aerosol generating device 1, may introduce external air or discharge internal air.

Although not illustrated in FIGS. 1 to 3, the aerosol generating device 1 and an additional cradle may form together a system. For example, the cradle may be used to charge the battery 11 of the aerosol generating device 1. Alternatively, the heater 13 may be heated when the cradle and the aerosol generating device 1 are coupled to each other.

The aerosol generating article 2 may be similar to a general combustive cigarette. For example, the aerosol generating article 2 may be divided into a first portion 21 including an aerosol generating material and a second portion 22 including a filter, etc. Alternatively, the second portion 22 of the aerosol generating article 2 may also include the aerosol generating material. For example, an aerosol generating material made in the form of granules or capsules may be inserted into the second portion 22.

The entire first portion 21 may be inserted into the aerosol generating device 1, and the second portion 22 may be exposed to the outside. Alternatively, only a portion of the first portion 21 may be inserted into the aerosol generating device 1, or the entire first portion 21 and a portion of the second portion 22 may be inserted into the aerosol generating device 1. The user may inhale an aerosol while holding the second portion 22 by the mouth of the user. In this case, the aerosol is generated by the external air passing through the first portion 21, and the generated aerosol passes through the second portion 22 and is delivered to the user's mouth.

For example, the external air may flow into at least one air passage formed in the aerosol generating device 1. For example, opening and closing of the air passage and/or a size of the air passage formed in the aerosol generating device 1 may be adjusted by the user. Accordingly, the amount and the quality of smoking may be adjusted by the user. As another example, the external air may flow into the aerosol generating article 2 through at least one hole formed in a surface of the aerosol generating article 2.

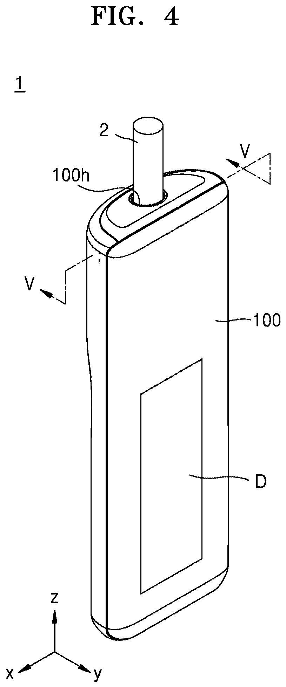

FIG. 4 is a perspective view of an aerosol generating device according to an embodiment.

Referring to FIG. 4, an aerosol generating device 1 according to an embodiment may include a housing 100 into which an aerosol generating article 2 may be inserted.

The housing 100 may form a general exterior of the aerosol generating device 1 and include an inner space in which components of the aerosol generating device 1 may be arranged. The drawing illustrates that the housing 110 has a semicircular cross-section, but the shape of the housing 100 is not limited thereto. For example, the shape of the housing 100 may generally be a cylinder or a polyprism (e.g., a triangular prism or a rectangular prism).

In the inner space of the housing 100, components for generating an aerosol by heating the aerosol generating article 2 inserted into the housing 100 and components for performing additional functions associated with the heating of the aerosol generating article may be arranged, and the components are described below in detail.

According to an embodiment, the housing 100 may include an opening 100h through which the aerosol generating article 2 may be inserted into the housing 100. At least a portion of the aerosol generating article 2 may be inserted or accommodated in the housing 100 through the opening 100h.

The aerosol generating article 2 inserted or accommodated in the housing 100 may be heated inside the housing 100, and as a result, aerosols may be generated. The user may inhale the aerosol discharged from the aerosol generating article 2.

The aerosol generating device 1 may further include a display D on which visual information is displayed.

The display D may be arranged such that at least some regions of the display D are exposed outside the housing 100. The aerosol generating device 1 may provide various pieces of visual information to the user through the display D.

For example, the aerosol generating device 1 may provide, through the display D, information regarding the insertion or accommodation of the aerosol generating article and/or information regarding whether the inserted aerosol generating article 2 is over-moisturized, but the information provided through the display D may be variously modified.

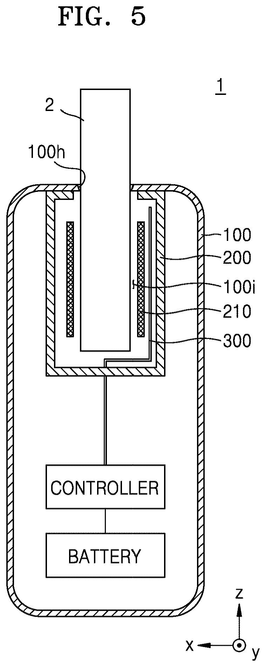

FIG. 5 is a schematic cross-sectional view showing the interior of the aerosol generating device of FIG. 4 and a cross-sectional view showing the aerosol generating device 1 in a V-V direction.

Referring to FIG. 5, the aerosol generating device 1 according to an embodiment may include the housing 100, the heater assembly 200, and a circuit board 300.

The housing 100 may include an accommodation space 100i in which the aerosol generating article 2 is accommodated. The aerosol generating article may be inserted into the aerosol generating device 1 through an opening (e.g., the opening 100h of FIG. 4), and accordingly, the aerosol generating article 2 may be accommodated in the accommodation space 100i of the housing 100.

The heater assembly 200 may be located in the inner space of the housing and generate an aerosol by heating the aerosol generating article accommodated in the accommodation space 100i. The heater assembly 200 may include a heater 210 for heating the aerosol generating article as power is supplied. In this case, the heater 210 may be the same as the heater 13 described above with reference to FIGS. 1 to 3.

At least a portion of the aerosol generating article accommodated in the accommodation space 100i may be heated by the heater 210, and as vaporized particles, generated from the heated aerosol generating article, are mixed with air introduced to the inner space of the housing 100 through the airflow path, an aerosol may be generated.

The circuit board 300 may include electronic components required for the operation of the aerosol generating device 1. The circuit board may be a flexible printed circuit board (FPCB). The circuit board 300 may be arranged to surround at least a portion of the accommodation space 100i inside the housing 100. FIG. 5 only shows that the circuit board 300 extends to surround a portion of the accommodation space 100i, but the circuit board 300 may extend to entirely surround the accommodation space 100i.

The circuit board 300 may include components for performing functions that may provide the user convenience to the user. In this case, when components that are functionally related to each other are integrated in the circuit board 300, various functions may be effectively implemented in a limited inner space of the aerosol generating device. For example, when the circuit board 300 is arranged inside the heater assembly 200, components for performing additional functions associated with the heating of the aerosol generating article may be integrated in the circuit board 300.

As an example of the components for performing the additional functions associated with the heating, the circuit board 300 may include a first sensor used to determine whether the aerosol generating article accommodated in the accommodation space 100i is over-moisturized. The term 'over-moisturized' may refer to a state in which the moisture content in the aerosol generating article is greater than a preset value or range. As another example, the circuit board 300 may include a second sensor used to determine whether the aerosol generating article is accommodated in the accommodation space 100i.

The components included in the circuit board 300 and functions thereof are not limited to the above examples. Hereinafter, the first sensor and the second sensor that are included in the circuit board and perform the additional functions associated with the heating of the aerosol generating article are described.

The first sensor may be a capacitance sensor. The controller may use the capacitance sensor to read a capacitance value that changes as the aerosol generating article 2 is accommodated in the accommodation space 100i.

The capacitance value may differ depending on whether the aerosol generating article is accommodated in the accommodation space 100i and the moisture content in the aerosol generating article. The controller may use the capacitance sensor to continuously read the capacitance value, according to a change in the capacitance value of the accommodation space 100i or the aerosol generating article over time.

The capacitance sensor may generate a signal corresponding to the change in the capacitance value of the accommodation space 100i. For example, when the capacitance value satisfies a preset condition, the capacitance sensor may generate a specific signal. In this case, the 'preset condition' may refer to various conditions, for example, a condition under which the capacitance value is in the preset range or greater than a preset threshold value. The controller electrically connected to the capacitance sensor may determine that the aerosol generating article is in the over-moisturized state, based on the specific signal from the capacitance sensor.

When determining that the aerosol generating article is in the over-moisturized state, the controller may control the heater to heat the aerosol generating article for a certain period of time. In this case, the expression 'certain period of time' may refer to a period of time during which the aerosol generating article is heated and the moisture content in the aerosol generating article is decreased to a certain level or less. To this end, the temperature of the aerosol inhaled by the user may be adjusted to the temperature appropriate for the user to inhale the aerosol, and thus, the user may have a satisfactory smoking sensation.

In addition, the controller may provide a notification recognized by the user through a user interface (e.g., the display D of FIG. 4) so that the user may not inhale the aerosol for a certain period of time during which the moisture content in the aerosol generating article is reduced.

The second sensor may be an inductive sensor. An 'inductance-to-digital converter (LDC) sensor' may be the inductive sensor. The controller may use the inductive sensor to read an inductance value changing according to the accommodation of the aerosol generating article 2 in the accommodation space 100i.

The inductance value may differ depending on whether the aerosol generating article is accommodated in the accommodation space 100i. For example, the inductance value may change because of a metal material, e.g., aluminum, which is arranged on the inner surface or the outer circumferential surface of the aerosol generating article. In this case, the inductance value may vary according to the type of the metal material. The controller may use the inductive sensor to continuously read the inductance value, according to the change of the inductance value over time.

The inductive sensor may generate a signal corresponding to the change of the inductance value of the accommodation space 100i. For example, when the inductance value satisfies a preset condition, the inductive sensor may generate a specific signal. The controller electrically connected to the inductive sensor may determine that the aerosol generating article is accommodated in the accommodation space 100i, based on the specific signal from the inductive sensor.

When determining that the aerosol generating article is accommodated in the accommodation space 100i, the controller may control the heater to heat the aerosol generating article for smoking. As a result, without any manipulation of the heater by the user, the heating of the aerosol generating article may be initiated simply by the user inserting the aerosol generating article into the housing 100.

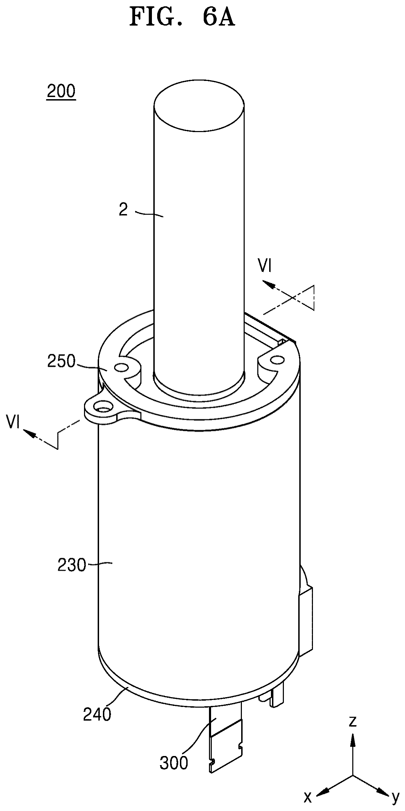

Hereinafter, referring to FIGS. 6A to 6C, the structure of the heater assembly 200 accommodating the circuit board 300 including the first sensor and the second sensor is described in detail.

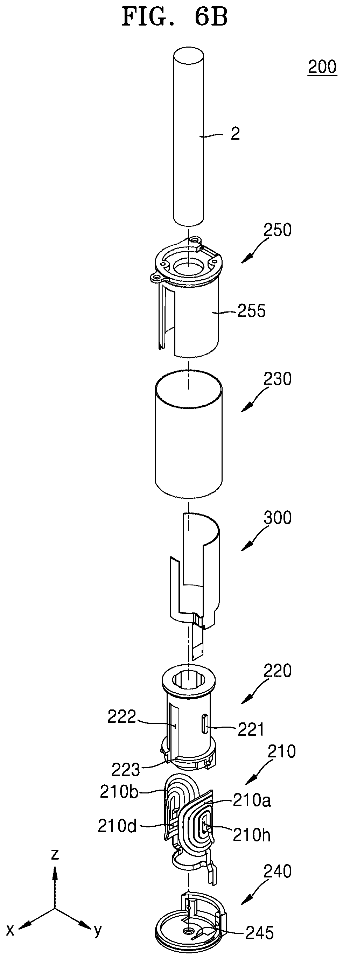

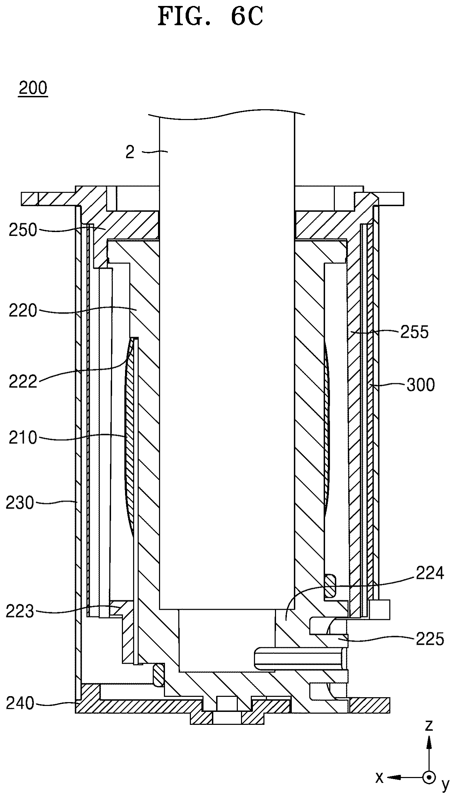

FIG. 6A is a perspective view of a heater assembly of the aerosol generating device of FIG. 5. FIG. 6B is an exploded perspective view of the heater assembly of FIG. 6A. FIG. 6C is a side cross-sectional view of the heater assembly of FIG. 6A in a VI-VI direction.

Referring to FIGS. 6A to 6C, the heater assembly 200 of the aerosol generating device 1 according to an embodiment may include the heater 210, an inner cylinder 220, an outer cylinder 230, a bottom wall 240, and an upper coupling member 250. Hereinafter, the descriptions that are already provided with reference to FIG. 5 are omitted.

The heater 210 may be arranged outside the inner cylinder 220. The circuit board 300 may be arranged outside the heater 210. The outer cylinder 230 may be arranged outside the circuit board 300. The bottom wall 240 may be arranged under the inner cylinder 220 and the outer cylinder 230 (e.g., in the -z direction). The upper coupling member 250 may be arranged above the inner cylinder 220 and the outer cylinder 230. At least a portion of the upper coupling member 250 may extend between the inner cylinder 220 and the outer cylinder 230.

The heater 210 may include an induction heater. For example, the heater 210 may include a coil (or 'electrically conductive coil') configured to generate an alternating magnetic field as power is supplied. The susceptor may generate heat by the alternating magnetic field, which is generated by the coil, to heat the aerosol generating article.

For example, the heater assembly 200 may include the susceptor. The inner cylinder 220 of the heater assembly 200 may be the susceptor. The susceptor may be arranged to surround at least a portion of the outer circumferential surface of the aerosol generating article inserted into the housing (e.g., the housing 100 of FIG. 5) and heat the aerosol generating article accommodated in the accommodation space 100i.

As another example, a separate susceptor may not be arranged in the heater assembly 200, and the aerosol generating article may include the susceptor. A metal material, such as aluminum, which is included in the aerosol generating article may be a susceptor that generates heat by the alternating magnetic field generated by the coil. The metal material that becomes the susceptor may be arranged on the inner surface or outer circumferential surface of the aerosol generating article.

When the susceptor is arranged inside the aerosol generating article, the susceptor may be arranged in the form of metal flakes. When the susceptor is arranged on the outer circumferential surface of the aerosol generating article, the susceptor may be arranged in the form of metal foil, such as aluminum foil. The metal flakes and the metal foil may be induced-heated by the magnetic field and generate heat. Also, the metal flakes and the metal foil may change the inductive value read by the inductive sensor.

When the aerosol generating article includes the metal flakes or the metal foil, the aerosol generating device may induce-heat the aerosol generating article without a separate susceptor and may use the inductive sensor to determine whether the aerosol generating article is accommodated.

Hereinafter, unless otherwise stated, the heater 210 may refer to a coil of the induction heater and be referred to as the 'coil' 210.

The coil 210 may have a spiral pancake shape surrounding at least a portion of the accommodation space 100i. In detail, in relation to the inner cylinder 220 including the accommodation space 100i, the coil 210 having the pancake shape is wound to form a plate shape covering a portion of the outer surface of the inner cylinder 220, and the center around which the spiral coil 210 is wound may be positioned at a point on the outer surface of the inner cylinder 220.

The description 'the coil 210 covering a portion of the outer surface of the inner cylinder 220' may imply the arrangement configuration in which the coil 210 is arranged such that the inner surface of the spiral coil 210 (hereinafter, referred to as the 'inner surface of the spiral coil') faces the outer surface of the inner cylinder 220. Therefore, the description 'the coil 210 covering a portion of the outer surface of the inner cylinder 220' may include both a configuration in which the coil 210 contacts the outer surface of the inner cylinder 220 and a configuration in which the coil 210 is spaced apart from the outer surface of the inner cylinder 220.

'The outer surface of the inner cylinder 220' refers to the outer side surface of the inner cylinder 220 that faces a direction away from the center of the inner cylinder 220 in a radial direction of the inner cylinder 220. 'The inner surface of the inner cylinder 220' refers to the inner side surface of the inner cylinder 220 that faces the aerosol generating article 2 accommodated in the inner cylinder 220 in the radial direction of the inner cylinder 220. The above expressions may be used in the same meaning below.

The spiral axis of the spiral coil 210 may cross the lengthwise direction of the inner cylinder 220. In this case, the term 'lengthwise direction' may refer to the z-axis direction and a direction extending in a direction of the inner cylinder 220. Also, the 'lengthwise direction' may refer to a direction in which the aerosol generating article 2 is inserted into the inner cylinder 220. The 'lengthwise direction' may be used in the same meaning below.

When the outer surface of the inner cylinder 220 includes a curved surface, the coil 210 may have a plate shape that is curved along the outer surface of the inner cylinder 220. That is, the cross-section of the inner cylinder 220 in a direction crossing the lengthwise direction of the inner cylinder 220 may have a circular arc shape.

The coil 210 may include an insertion hole 210h at the center of the coil 210 that is spirally wound. The coil 210 may be coupled to the inner cylinder 220 through the insertion hole 210h and supported by the inner cylinder 220.

The coil 210 may include a plurality of pancake shapes. Referring to FIG. 6B, two pancake shapes form a pair and are electrically connected to each other, thus forming one coil 210. Based on the pancake shape, the coil 210 includes a first portion 210a and a second portion 210b.

The first portion 210a and the second portion 210b may have the same size and shape and be arranged symmetrically relative to the central axis of the inner cylinder 220. The first portion 210a and the second portion 210b may be electrically connected to each other by a third portion (not shown). The third portion may connect an edge of the first portion 210a to an edge of the second portion 210b.

A fourth portion 210d, which is arranged symmetrically to the third portion relative to the central axis of the inner cylinder 220, may be an empty space generated as the edges of the first portion 210a and the second portion 210b are separated from each other. A portion of the circuit board may be arranged on the fourth portion 210d.

Although not shown in the drawings, both ends of the coil 210 may extend respectively in the lengthwise direction along the outer surface of the inner cylinder 220 at the center of the coil 210 which is spirally wound, and be connected to other components (e.g., the battery).

The inner cylinder 220 may be arranged inside the housing (e.g., the housing 100 of FIG. 5) and form the accommodation space 100i for accommodating at least a portion of the aerosol generating article 2 that is inserted into the housing through the opening. The inner surface of the inner cylinder 220 may support the outer side surface of the aerosol generating article.

The inner cylinder 220 may include a protrusion 221 protruding to the outside. The protrusion 221 may be inserted into the insertion hole 210h of the coil 210 arranged outside the inner cylinder 220. Accordingly, the spiral coil 210 may be supported not to be moved by the inner cylinder 220. The shape of the protrusion 221 may correspond to the shape of the insertion hole 210h.

In an outer side of the inner cylinder 220, a groove portion 222 in which a portion of the circuit board 300 may be accommodated may be included. The groove portion 222 may extend in the lengthwise direction and the circumferential direction of the inner cylinder 220 to correspond to the size of the circuit board 300 accommodated in the groove portion 222.

The inner cylinder 220 may further include a guide portion 223 guiding the coupling of the circuit board 300, wherein the guide portion 223 is located on at least a portion of the lower portion of the inner cylinder 220. The guide portion 223 may protrude from the outer surface of the inner cylinder 220 along the circumferential direction of the inner cylinder 220 to make the circuit board 300 be coupled at a designated location of the inner cylinder 220.

A support 224 may be included inside the inner cylinder 220, the support supporting an end portion of the aerosol generating article. The support 224 may protrude from the inner surface of the inner cylinder 220. The support 224 may separate the aerosol generating article 2 from the bottom surface of the inner cylinder 220.

The inner cylinder 220 may include an air inlet 225 in the outer surface of the inner cylinder 220, the air inlet being configured to transmit air to the accommodation space 100i. The air introduced to the inner cylinder 220 through the air inlet 225 may move to an end portion of the aerosol generating article accommodated in the accommodation space 100i.

The outer cylinder 230 may form a portion of the exterior of the heater assembly 200 (e.g., the outer circumferential surface of the heater assembly 200) and accommodate and protect the components of the heater assembly 200.

The outer cylinder 230 may be separated from the outer side of the inner cylinder 220 and the upper coupling member 250 and surround the inner cylinder 220 and the upper coupling member 250. The outer cylinder 230 may be open in the lengthwise direction of the inner cylinder 220 (e.g., in the z-axis direction). Accordingly, the outer cylinder 230 may have a pipe shape that is open in the z-axis direction. The outer cylinder 230 may be open at a location corresponding to the air inlet 225 of the inner cylinder 220 to allow air to be introduced to the inside of the heater assembly 200.

The outer cylinder 230 may block the heat, which is generated inside the heater assembly 200, to be transmitted to the outside. To increase the insulation efficiency, the outer cylinder 230 may form an 'insulation space' together with the bottom wall 240 and the upper coupling member 250. The outer cylinder 230 may include a plastic material that does not transmit heat well, or a metal material coated with a thermal shielding material. For example, the outer cylinder 230 may include an aluminum material.

The bottom wall 240 may be arranged on the lower portion of the inner cylinder 220 and form a portion of the exterior of the heater assembly 200 (e.g., the bottom wall of the heater assembly 200). The bottom wall 240 may be coupled to a side (e.g., the lower portion) of the outer cylinder 230 and close a side of the insulation space.

The bottom wall 240 may support the inner cylinder 220 arranged inside the insulation space. The bottom wall 240 may include a hole that is open towards the inner cylinder 220. A portion of the lower portion of the inner cylinder 220 may be inserted into the hole of the bottom wall 240 and coupled to the bottom wall 240.

The bottom wall 240 may include a passage 245 that connects the inside of the heater assembly 200 to the outside thereof. A portion of the circuit board 300 arranged inside the heater assembly 200 may penetrate the passage 245 and extend out of the heater assembly 200.

A portion of the edge of the bottom wall 240 may extend towards the inner cylinder 220. The extending portion of the bottom wall 240 may engage with an open portion of the outer cylinder 230 at a location corresponding to the air inlet 225 and may be arranged on the outer side of the air inlet 225 to support the air inlet 225. For the introduction of air through the air inlet 225, the extending portion of the bottom wall 240 may be open at the location corresponding to the air inlet 225.

The upper coupling member 250 may be arranged on the upper portion of the inner cylinder 220 and form a portion of the exterior of the heater assembly 200 (e.g., the upper wall of the heater assembly 200). The upper coupling member 250 may be coupled to the other side (e.g., an upper portion) of the outer cylinder 230 and partially close the other side of the insulation space. A portion of the upper coupling member 250 may be open to the outside, allowing the aerosol generating article to pass through and be accommodated in the accommodation space.

The upper coupling member 250 may include a configuration that engages with the upper portion of the inner cylinder 220. Therefore, the inner cylinder 220 may be supported by the upper coupling member 250 within the insulation space.

The upper coupling member 250 may include a cover 255 extending in the lengthwise direction of the inner cylinder 220 to surround a portion of the outer circumference of the inner cylinder 220. The cover 255 may extend to a location corresponding to the air inlet 225 of the inner cylinder 220. Other components outside the cover 255 may contact a portion of the cover 255 and be supported by the cover 255.

A portion of the upper coupling member 250, on which the cover 255 is not arranged, may be open. The open portion of the upper coupling member 250 may be used as a space in which other components in the heater assembly 200 may be arranged.

The term 'insulation structure' is used as a collective term for the structure including the outer cylinder 230, the bottom wall 240, and the upper coupling member 250. The insulation structure may seal the heater assembly 200 to prevent droplets, which are generated while the aerosol is generated using the heater, from being discharged outside the heater assembly 200. Therefore, malfunction or damage to the components of the aerosol generating device 1 by the droplets may be prevented.

In addition, the insulation structure may seal the heater assembly 200 and prevent heat generated inside the heater assembly 200 from being delivered to the housing. The insulation structure may prevent the transmission of high-temperature heat to a body part (e.g., palm) of the user holding the housing even when the temperature of the heater is maintained at a high level.

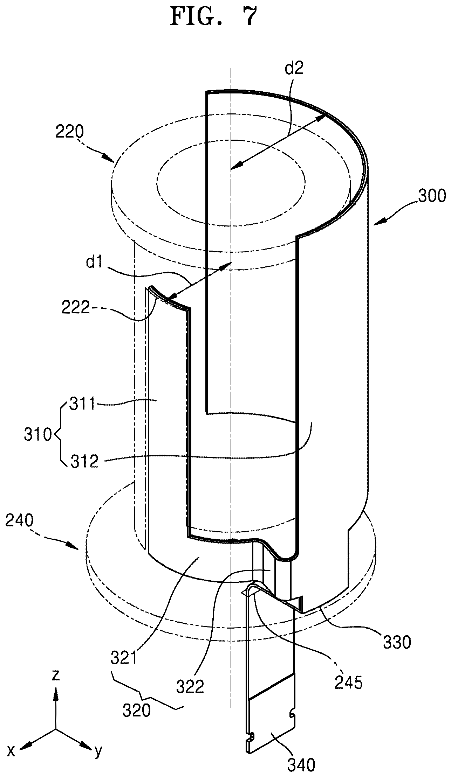

Hereinafter, with reference to FIG. 7, the structure of the circuit board 300 corresponding to the components of the heater assembly 200 is described in detail.

FIG. 7 is a perspective view of the circuit board of FIG. 6B.

Referring to FIG. 7, the circuit board 300 may include an extension 310, a connecting portion 320, a bending portion 330, and a terminal 340. Reference numerals of components that are not shown in FIG. 7 are referenced in the heater assembly 200 of FIGS. 6A to 6C. In FIG. 7, the components indicated by the dashed line may denote a virtual inner cylinder 220 and a virtual bottom wall 240 that are conceptually outlined.

The circuit board 300 may include the extension 310 extending along the circumferential direction of the inner cylinder 220 to surround at least a portion of the inner cylinder 220 including the accommodation space 100i. FIG. 7 shows that the circuit board 300 extends to surround at least a portion of the inner cylinder 220, but the circuit board 300 may extend to entirely surround the inner cylinder 220.

The extension 310 may include a first extension 311 and a second extension 312 that are apart from each other in the circumferential direction of the inner cylinder 220. Among the first extension 311 and the second extension 312, a portion of the extension 310 that is positioned closer to the inner cylinder 220 is referred to as the first extension 311.

On the first extension 311, the capacitance sensor that is the first sensor may be arranged. On the second extension 312, the inductive sensor that is the second sensor may be arranged. However, the arrangements of the sensors are not limited to the above examples.

When the outer surface of the inner cylinder 220 includes a curved surface, the first extension 311 and the second extension 312 may have plate shapes that are curved along the outer surface of the inner cylinder 220. The cross-section of the circuit board 300 in a direction crossing the lengthwise direction of the inner cylinder 220 may have a circular arc shape because of the extension 310.

The first extension 311 and the second extension 312 may face each other relative to the central axis in the lengthwise direction of the inner cylinder 220. In this case, the first sensor arranged on the first extension 311 may be arranged adjacent to the lower portion of the inner cylinder 220, and the second sensor arranged on the second extension 312 may be arranged adjacent to the upper portion of the inner cylinder 220. That is, the first sensor and the second sensor may face each other but be arranged apart from each other along the lengthwise direction of the inner cylinder 220. The arrangement of the first sensor and the second sensor is not limited to the above example.

A distance d1 to the first extension 311 from the central axis in the lengthwise direction of the inner cylinder 220 may be less than a distance d2 to the second extension 312 from the central axis in the lengthwise direction of the inner cylinder 220. Accordingly, the first extension 311 of the circuit board 300 protrudes towards the inner cylinder 220 with respect to the second extension 312.

The first extension 311 may be supported by the inner cylinder 220. For example, the first extension 311 may be accommodated in the groove portion 222 and supported by the same. The second extension 312 may be spaced apart from the outer surface of the inner cylinder 220 at a certain distance. In this case, the term 'certain distance' may refer to a distance obtained by subtracting the distance d1 to the first extension 311 from the central axis in the lengthwise direction of the inner cylinder 220 from the distance d2 to the second extension 312 from the central axis in the lengthwise direction of the inner cylinder 220.

In the lengthwise direction of the inner cylinder 220, the length of the first extension 311 may be less than that of the second extension 312. For example, based on the bottom surface of the inner cylinder 220, the second extension 312 may extend longer than the first extension 311. In the circumferential direction of the inner cylinder 220, the width of the first extension 311 may be less than that of the second extension 312. Accordingly, the area of the first extension 311 may be less than that of the second extension 312.

The circuit board 300 may include the connecting portion 320 that connects the first extension 311 and the second extension 312 and surrounds an outer circumference of the inner cylinder 220. The connecting portion 320 may include a first connecting portion 321 extending alongside the inner cylinder 220 and a second connecting portion 322 extending in a direction crossing the inner cylinder 220. The connecting portion 320 may be coupled to a portion of the lower portion of the inner cylinder 220 and supported by the inner cylinder 220.

The circuit board 300 may include the bending portion 330 that is bent on the lower portion of the second extension 312 to face the bottom surface of the inner cylinder 220 (e.g., a surface in the z-axis direction). An end portion of the bending portion 330 may be connected to the second extension 312, and the bending portion 330 may extend from the second extension 312 to the inner cylinder 220. The bending portion 330 may be coupled to the inner cylinder 220 and a portion of the bottom wall 240 positioned on the lower portion of the bending portion 330 and be supported by the bottom wall 240.

The circuit board 300 may include the terminal 340 that extends the other end of the bending portion 330 in a direction away from the lower surface of the bottom wall of the inner cylinder 220. The terminal 340 may pass through the passage 245 of the bottom wall 240 and extend out of the heater assembly 200. The terminal 340 may extend in a direction away from the lower portion of the housing in the lengthwise direction of the housing (e.g., the housing 100 of FIG. 5). The terminal 340 may be electrically connected to another component (e.g., a main circuit board including a controller) of the aerosol generating device.

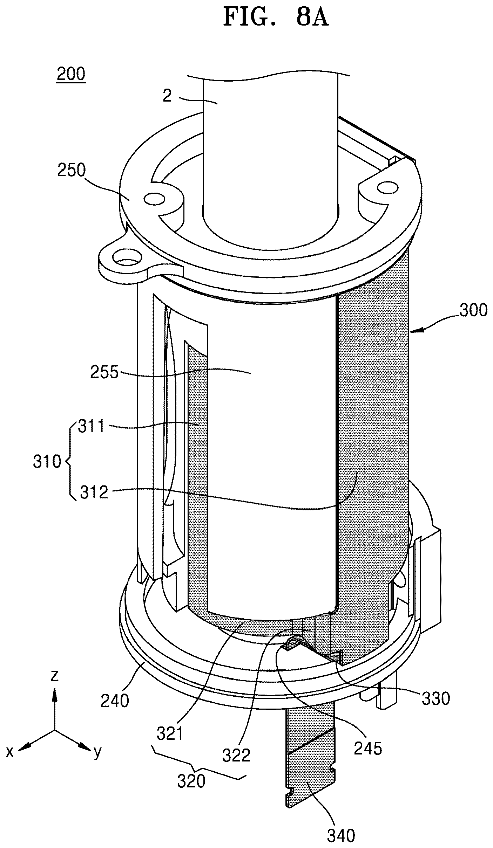

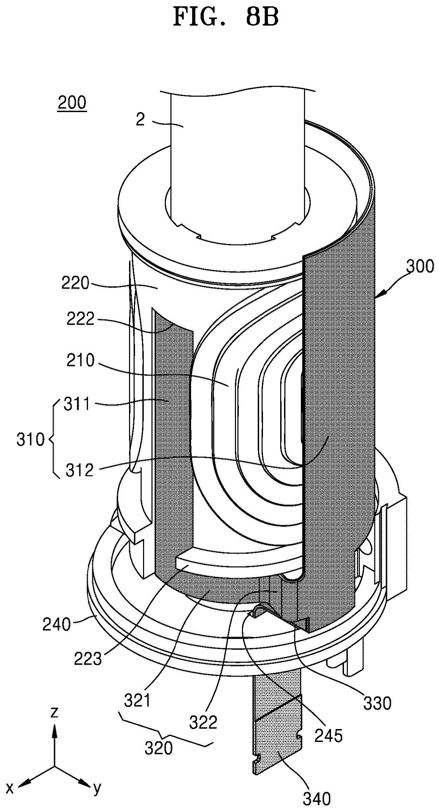

Hereinafter, with reference to FIGS. 8A and 8B, the arrangement relationship between the circuit board 300 and the components of the heater assembly 200 is described.

FIG. 8A is a perspective view of the heater assembly of FIG. 6A from which an outer cylinder is removed. FIG. 8B is a perspective view of the heater assembly of FIG. 8A from which an upper coupling member is removed.

Referring to FIGS. 8A and 8B, the aerosol generating device according to an embodiment may include the heater assembly 200 and the circuit board 300. The heater assembly 200 may include the coil 210, the inner cylinder 220, the outer cylinder 230, the bottom wall 240, and the upper coupling member 250. Reference numerals of components that are not shown in FIGS. 8A and 8B are referenced in the heater assembly 200 of FIGS. 6A to 6C and the circuit board 300 of FIG. 7.

In relation to the arrangement of the circuit board 300 and the coil 210, the first extension 311 may be arranged on the fourth portion 210d that is the empty space between the first portion 210a and the second portion 210b of the coil 210 having the spiral pancake shape. The first sensor that is the capacitance sensor may be arranged between two pancake shapes of the coil 210. Because the capacitance sensor may be arranged to be coupled to the inner cylinder 220 including the accommodation space, the performance of the capacitance sensor may be improved.

The second extension 312 may be arranged outside the coil 210. In this case, the second extension 312 may extend from the location corresponding to the center of the coil 210, which is spirally wound, in the circumferential direction of the inner cylinder 220.

In relation to the arrangement of the circuit board 300 and the inner cylinder 220, the first extension 311 may be accommodated in the groove portion 222 of the inner cylinder 220 and coupled to the inner cylinder 220. In this case, the groove portion 222 may be arranged at a location corresponding to the fourth portion 210d of the coil 210. Because the groove portion 222 of the inner cylinder 220, in which the first extension 311 may be accommodated, is arranged between two pancake shapes of the coil 210, the capacitance sensor may be arranged closer to the aerosol generating article accommodated in the accommodation space.

The second extension 312 may be arranged apart from the inner cylinder 220. The first connecting portion 321 may extend along the guide portion 223 on the lower portion of the guide portion 223 and be coupled to the outer surface of the inner cylinder 220. Because the guide portion 223 is not arranged in the portion in which the groove portion 222 is arranged, the first extension 311 and the first connecting portion 321 may be coupled to engage with the groove portion 222 and the guide portion 223.

The second connecting portion 322 may extend in a direction crossing the inner cylinder 220. On the lower portion of the guide portion 223, the second connecting portion 322 may be coupled to a portion of the inner cylinder 220 that protrudes to the outside of the inner cylinder 220.

In relation to the arrangement of the circuit board 300 and the outer cylinder 230, the circuit board 300 may be arranged inside the outer cylinder 230.

In relation to the arrangement of the circuit board 300 and the bottom wall 240, the first extension 311 and the second extension 312 may extend in a direction facing the inner cylinder 220 from the bottom wall 240. In this case, the second extension 312 may extend to a location close to the upper coupling member 250.

A portion of the bending portion 330 may be supported by a portion of the bottom wall 240 that protrudes from an edge of the bottom wall 240 to the upper portion of the bottom wall 240. The terminal 340 may pass through the passage 245 of the bottom wall 240 and extend towards the lower portion of the aerosol generating device 1.

In relation to the arrangement of the circuit board 300 and the upper coupling member 250, the second extension 312 may be coupled to the outer side of the cover 255 of the upper coupling member 250 and supported by the upper coupling member 250. The second extension 312 may extend, in the lengthwise direction of the inner cylinder 220, from an end portion of the cover 255 to the other end portion of the cover 255, wherein the end portion is located on the upper portion of the inner cylinder 220 and the other end portion is adjacent to the air inlet 225 of the inner cylinder 220.

The circuit board 300 of the aerosol generating device 1 according to an embodiment may include the first sensor that is the capacitance sensor and the second sensor that is the inductive sensor. The first sensor may be arranged on the first extension 311. The second sensor may be arranged on the second extension 312.

The circuit board 300 of the aerosol generating device 1 according to an embodiment may be supported by the components of the heater assembly 200. The first extension 311 and the connecting portion 320 may be supported by the inner cylinder 220. The bending portion 330 may be supported by the bottom wall 240. The second extension 312 may be supported by the upper coupling member 250.

In an aerosol generating device according to the one or more embodiments, a capacitance sensor and an inductive sensor are integrated into one circuit board and arranged adjacent to a heater, and thus, a limited inner space of the aerosol generating device may be effectively utilized.

In addition, in the aerosol generating device according to the one or more embodiments, the integration of the capacitance sensor and the inductive sensor into one circuit board may help simplify manufacturing processes and reduce manufacturing costs of the aerosol generating device in terms of the assembly of the aerosol generating device.

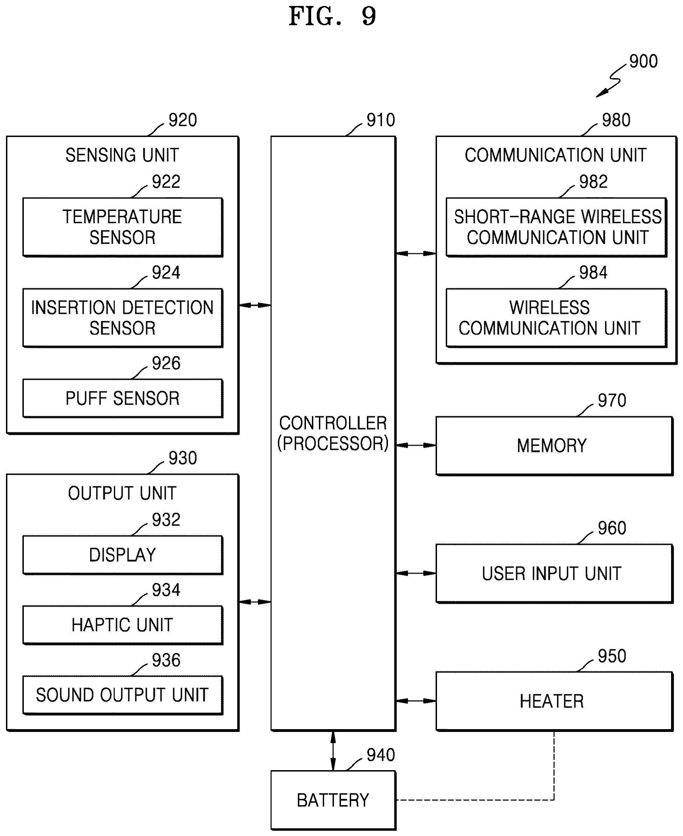

FIG. 9 is a block diagram of an aerosol generating device 900 according to another embodiment.

The aerosol generating device 900 may include a controller 910, a sensing unit 920, an output unit 930, a battery 940, a heater 950, a user input unit 960, a memory 970, and a communication unit 980. However, the internal structure of the aerosol generating device 900 is not limited to those illustrated in FIG. 9. That is, according to the design of the aerosol generating device 900, it will be understood by one of ordinary skill in the art that some of the components shown in FIG. 9 may be omitted or new components may be added.

The sensing unit 920 may sense a state of the aerosol generating device 900 and a state around the aerosol generating device 900, and transmit sensed information to the controller 910. Based on the sensed information, the controller 910 may control the aerosol generating device 900 to perform various functions, such as controlling an operation of the heater 950, limiting smoking, determining whether an aerosol generating article (e.g., a cigarette, a cartridge, or the like) is inserted, displaying a notification, or the like.

The sensing unit 920 may include at least one of a temperature sensor 922, an insertion detection sensor, and a puff sensor 926, but is not limited thereto.

The temperature sensor 922 may sense a temperature at which the heater 950 (or an aerosol generating material) is heated. The aerosol generating device 900 may include a separate temperature sensor for sensing the temperature of the heater 950, or the heater 950 may serve as a temperature sensor. Alternatively, the temperature sensor 922 may also be arranged around the battery 940 to monitor the temperature of the battery 940.

The insertion detection sensor 924 may sense insertion and/or removal of an aerosol generating article. For example, the insertion detection sensor 924 may include at least one of a film sensor, a pressure sensor, an optical sensor, a resistive sensor, a capacitive sensor, an inductive sensor, and an infrared sensor, and may sense a signal change according to the insertion and/or removal of an aerosol generating article.

The puff sensor 926 may sense a user's puff on the basis of various physical changes in an airflow passage or an airflow channel. For example, the puff sensor 926 may sense a user's puff on the basis of any one of a temperature change, a flow change, a voltage change, and a pressure change.

The sensing unit 920 may include, in addition to the temperature sensor 922, the insertion detection sensor 924, and the puff sensor 926 described above, at least one of a temperature/humidity sensor, a barometric pressure sensor, a magnetic sensor, an acceleration sensor, a gyroscope sensor, a location sensor (e.g., a global positioning system (GPS)), a proximity sensor, and a red-green-blue (RGB) sensor (illuminance sensor). Because a function of each of sensors may be intuitively inferred by one of ordinary skill in the art from the name of the sensor, a detailed description thereof may be omitted.

The output unit 930 may output information on a state of the aerosol generating device 900 and provide the information to a user. The output unit 930 may include at least one of a display unit 932, a haptic unit 934, and a sound output unit 936, but is not limited thereto. When the display unit 932 and a touch pad form a layered structure to form a touch screen, the display unit 932 may also be used as an input device in addition to an output device.

The display unit 932 may visually provide information about the aerosol generating device 900 to the user. For example, information about the aerosol generating device 900 may mean various pieces of information, such as a charging/discharging state of the battery 940 of the aerosol generating device 900, a preheating state of the heater 950, an insertion/removal state of an aerosol generating article, or a state in which the use of the aerosol generating device 900 is restricted (e.g., sensing of an abnormal object), or the like, and the display unit 932 may output the information to the outside. The display unit 932 may be, for example, a liquid crystal display panel (LCD), an organic light-emitting diode (OLED) display panel, or the like. In addition, the display unit 932 may be in the form of a light-emitting diode (LED) light-emitting device.

The haptic unit 934 may tactilely provide information about the aerosol generating device 900 to the user by converting an electrical signal into a mechanical stimulus or an electrical stimulus. For example, the haptic unit 934 may include a motor, a piezoelectric element, or an electrical stimulation device.

The sound output unit 936 may audibly provide information about the aerosol generating device 900 to the user. For example, the sound output unit 936 may convert an electrical signal into a sound signal and output the same to the outside.

The battery 940 may supply power used to operate the aerosol generating device 900. The battery 940 may supply power such that the heater 950 may be heated. In addition, the battery 940 may supply power required for operations of other components (e.g., the sensing unit 920, the output unit 930, the user input unit 960, the memory 970, and the communication unit 980) in the aerosol generating device 900. The battery 940 may be a rechargeable battery or a disposable battery. For example, the battery 940 may be a lithium polymer (LiPoly) battery, but is not limited thereto.

The heater 950 may receive power from the battery 940 to heat an aerosol generating material. Although not illustrated in FIG. 9, the aerosol generating device 900 may further include a power conversion circuit (e.g., a direct current (DC)/DC converter) that converts power of the battery 940 and supplies the same to the heater 950. In addition, when the aerosol generating device 900 generates aerosols in an induction heating method, the aerosol generating device 900 may further include a DC/alternating current (AC) converter that converts DC power of the battery 940 into AC power.

The controller 910, the sensing unit 920, the output unit 930, the user input unit 960, the memory 970, and the communication unit 980 may each receive power from the battery 940 to perform a function. Although not illustrated in FIG. 9, the aerosol generating device 900 may further include a power conversion circuit that converts power of the battery 940 to supply the power to respective components, for example, a low dropout (LDO) circuit, or a voltage regulator circuit.

In an embodiment, the heater 950 may be formed of any suitable electrically resistive material. For example, the suitable electrically resistive material may be a metal or a metal alloy including titanium, zirconium, tantalum, platinum, nickel, cobalt, chromium, hafnium, niobium, molybdenum, tungsten, tin, gallium, manganese, iron, copper, stainless steel, nichrome, or the like, but is not limited thereto. In addition, the heater 950 may be implemented by a metal wire, a metal plate on which an electrically conductive track is arranged, a ceramic heating element, or the like, but is not limited thereto.

In another embodiment, the heater 950 may be a heater of an induction heating type. For example, the heater 950 may include a susceptor that heats an aerosol generating material by generating heat through a magnetic field applied by a coil.

The user input unit 960 may receive information input from the user or may output information to the user. For example, the user input unit 960 may include a key pad, a dome switch, a touch pad (a contact capacitive method, a pressure resistance film method, an infrared sensing method, a surface ultrasonic conduction method, an integral tension measurement method, a piezo effect method, or the like), a jog wheel, a jog switch, or the like, but is not limited thereto. In addition, although not illustrated in FIG. 9, the aerosol generating device 900 may further include a connection interface, such as a universal serial bus (USB) interface, and may connect to other external devices through the connection interface, such as the USB interface, to transmit and receive information, or to charge the battery 940.

The memory 970 is a hardware component that stores various types of data processed in the aerosol generating device 900, and may store data processed and data to be processed by the controller 910. The memory 970 may include at least one type of storage medium from among a flash memory type, a hard disk type, a multimedia card micro type memory, a card-type memory (for example, secure digital (SD) or extreme digital (XD) memory, etc.), random access memory (RAM), static random access memory (SRAM), read-only memory (ROM), electrically erasable programmable read-only memory (EEPROM), programmable read-only memory (PROM), a magnetic memory, a magnetic disk, and an optical disk. The memory 970 may store an operation time of the aerosol generating device 900, the maximum number of puffs, the current number of puffs, at least one temperature profile, data on a user's smoking pattern, etc.

The communication unit 980 may include at least one component for communication with another electronic device. For example, the communication unit 980 may include a short-range wireless communication unit 982 and a wireless communication unit 984.

The short-range wireless communication unit 982 may include a Bluetooth communication unit, a Bluetooth Low Energy (BLE) communication unit, a near field communication unit, a wireless LAN (WLAN) (Wi-Fi) communication unit, a Zigbee communication unit, an infrared data association (IrDA) communication unit, a Wi-Fi Direct (WFD) communication unit, an ultra-wideband (UWB) communication unit, an Ant+ communication unit, or the like, but is not limited thereto.

The wireless communication unit 984 may include a cellular network communication unit, an Internet communication unit, a computer network (e.g., local area network (LAN) or wide area network (WAN)) communication unit, or the like, but is not limited thereto. The wireless communication unit 984 may also identify and authenticate the aerosol generating device 900 within a communication network by using subscriber information (e.g., International Mobile Subscriber Identifier (IMSI)).

The controller 910 may control general operations of the aerosol generating device 900. In an embodiment, the controller 910 may include at least one processor. The processor may be implemented as an array of a plurality of logic gates or may be implemented as a combination of a general-purpose microprocessor and a memory in which a program executable by the microprocessor is stored. It will be understood by one of ordinary skill in the art that the processor may be implemented in other forms of hardware.

The controller 910 may control the temperature of the heater 950 by controlling supply of power of the battery 940 to the heater 950. For example, the controller 910 may control power supply by controlling switching of a switching element between the battery 940 and the heater 950. In another example, a direct heating circuit may also control power supply to the heater 950 according to a control command of the controller 910.

The controller 910 may analyze a result sensed by the sensing unit 920 and control subsequent processes to be performed. For example, the controller 910 may control power supplied to the heater 950 to start or end an operation of the heater 950 on the basis of a result sensed by the sensing unit 920. As another example, the controller 910 may control, based on a result sensed by the sensing unit 920, an amount of power supplied to the heater 950 and the time the power is supplied, such that the heater 950 may be heated to a certain temperature or maintained at an appropriate temperature.

The controller 910 may control the output unit 930 on the basis of a result sensed by the sensing unit 920. For example, when the number of puffs counted through the puff sensor 926 reaches a preset number, the controller 910 may notify the user that the aerosol generating device 900 will soon be terminated through at least one of the display unit 932, the haptic unit 934, and the sound output unit 936.

One embodiment may also be implemented in the form of a computer-readable recording medium including instructions executable by a computer, such as a program module executable by the computer. The computer-readable recording medium may be any available medium that may be accessed by a computer and includes both volatile and nonvolatile media, and removable and non-removable media. In addition, the computer-readable recording medium may include both a computer storage medium and a communication medium. The computer storage medium includes all of volatile and nonvolatile media, and removable and non-removable media implemented by any method or technology for storage of information such as computer-readable instructions, data structures, program modules, or other data. The communication medium typically includes computer-readable instructions, data structures, other data in modulated data signals such as program modules, or other transmission mechanisms, and includes any information transfer media.

The descriptions of the above-described embodiments are merely examples, and it will be understood by one of ordinary skill in the art that various changes and equivalents thereof may be made. Therefore, the scope of the disclosure should be defined by the appended claims, and all differences within the scope equivalent to those described in the claims will be construed as being included in the scope of protection defined by the claims.

## Claims

1. An aerosol generating device comprising:
a housing comprising an accommodation space for accommodating an aerosol generating article;
a heater configured to heat the aerosol generating article accommodated in the accommodation space; and
a circuit board comprising a first sensor, which is configured to sense a capacitance change in the accommodation space, and a second sensor, which is configured to sense an inductance change in the accommodation space.

2. The aerosol generating device of claim 1, wherein the circuit board comprises a flexible printed circuit board (FPCB) surrounding at least a portion of the accommodation space within the housing.

3. The aerosol generating device of claim 1, wherein the circuit board comprises a first extension and a second extension, which extend to surround at least a portion of the accommodation space within the housing, the first sensor is arranged on the first extension, the second sensor is arranged on the second extension, and
at least a portion of the first extension is arranged apart from the second extension.

4. The aerosol generating device of claim 1, wherein the circuit board comprises a first extension and a second extension, which extend to surround at least a portion of the accommodation space within the housing, the first sensor is arranged on the first extension, the second sensor is arranged on the second extension, and
a distance to the first extension from a central axis in a lengthwise direction of the accommodation space is less than a distance to the second extension from the central axis in the lengthwise direction of the accommodation space.

5. The aerosol generating device of claim 1, wherein the circuit board comprises a first extension and a second extension which extend to surround at least a portion of the accommodation space within the housing, the first sensor is arranged on the first extension, the second sensor is arranged on the second extension, and
a width of the first extension in a circumferential direction of the accommodation space is less than a width of the second extension in the circumferential direction of the accommodation space.

6. The aerosol generating device of claim 1, wherein the circuit board comprises a first extension and a second extension which extend to surround at least a portion of the accommodation space within the housing, the first sensor is arranged on the first extension, the second sensor is arranged on the second extension, and
a length of the first extension in a lengthwise direction of the accommodation space is less than a length of the second extension in the lengthwise direction of the accommodation space.

7. The aerosol generating device of claim 1, wherein the circuit board comprises a first extension and a second extension which extend to surround at least a portion of the accommodation space within the housing, the first sensor is arranged on the first extension, the second sensor is arranged on the second extension, and
the first extension faces the second extension.

8. The aerosol generating device of claim 1, wherein the heater comprises a coil configured to generate an alternating magnetic field towards the accommodation space, and
the circuit board comprises an extension on which the second sensor is arranged and which is arranged on an outer side of the coil.

9. The aerosol generating device of claim 1, wherein the heater comprises a coil configured to generate an alternating magnetic field towards the accommodation space,
the coil has at least two spiral pancake shapes surrounding at least a portion of the accommodation space, and
the circuit board comprises an extension on which the first sensor is arranged and which is arranged between the at least two spiral pancake shapes in a circumferential direction of the accommodation space.

10. The aerosol generating device of claim 1, wherein the heater comprises a coil configured to generate an alternating magnetic field towards the accommodation space, and
the aerosol generating device further comprises a susceptor comprising the accommodation space and configured to generate heat by a magnetic field generated by the coil.

11. The aerosol generating device of claim 1, wherein the heater comprises a coil configured to generate an alternating magnetic field towards the accommodation space, and
the coil is configured to generate an alternating magnetic field towards the accommodation space to induce-heat metal foil of the aerosol generating article.

12. The aerosol generating device of claim 11, wherein the second sensor is configured to generate a signal by sensing an inductance change made by the metal foil of the aerosol generating article when the aerosol generating article is accommodated in the accommodation space.

13. The aerosol generating device of claim 1, further comprising an inner cylinder comprising the accommodation space and supporting the aerosol generating article accommodated in the accommodation space,
wherein the inner cylinder further comprises a groove portion accommodating the circuit board, and
a portion of the circuit board is accommodated in the groove portion and supported by the inner cylinder.

14. The aerosol generating device of claim 13, further comprising a bottom wall arranged on a lower portion of the inner cylinder and comprising a passage through which the circuit board passes,
wherein the circuit board further comprises a bending portion that is bent to face the bottom wall and supported by the bottom wall.

15. The aerosol generating device of claim 13, further comprising an upper coupling member arranged on an upper portion of the inner cylinder and surrounding the aerosol generating article,
wherein the upper coupling member comprises a cover extending in the lengthwise direction of the inner cylinder to surround a portion of an outer circumference of the inner cylinder, and
another portion of the circuit board is supported by the cover.
